(19) Europäisches Patentamt
European Patent Office
Office européen des brevets

(11) **EP 4 737 461 A1**

(12) **EUROPEAN PATENT APPLICATION**
published in accordance with Art. 153(4) EPC

(43) Date of publication:
**06.05.2026 Bulletin 2026/19**

(21) Application number: **24832455.0**

(22) Date of filing: **27.06.2024**

(51) International Patent Classification (IPC):
***C07F 7/00*** *(2006.01)* ***C07F 7/28*** *(2006.01)*
***C23C 16/18*** *(2006.01)* ***C23C 16/455*** *(2006.01)*

(52) Cooperative Patent Classification (CPC):
**C07F 7/00; C07F 7/28; C23C 16/18; C23C 16/455**

(86) International application number:
**PCT/KR2024/008949**

(87) International publication number:
**WO 2025/005677 (02.01.2025 Gazette 2025/01)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.06.2023 KR 20230082470**

(71) Applicant: **Hansol Chemical Co., Ltd**
**Seoul 06169 (KR)**

(72) Inventors:
- **PARK, Cheol-Wan**
  **Wanju-gun, Jeonbuk-do 55321 (KR)**
- **KIM, Hyun-Kee**
  **Jeonju-si, Jeonbuk-do 55147 (KR)**
- **SHIN, Ee-Seul**
  **Ulsan 44745 (KR)**
- **PARK, Kwan-Hyun**
  **Wanju-gun, Jeonbuk-do 55321 (KR)**
- **PARK, Jung-Woo**
  **Seoul 05503 (KR)**

(74) Representative: **Louis Pöhlau Lohrentz**
**Patentanwälte**
**Postfach 30 55**
**90014 Nürnberg (DE)**

(54) **NOVEL COMPOUND, PRECURSOR COMPOSITION COMPRISING SAME, AND METHOD FOR MANUFACTURING THIN FILM USING SAME**

(57) The present invention relates to a vapor deposition compound capable of depositing a thin film through vapor deposition and, more specifically, to: a novel compound that can be applied to atomic layer deposition (ALD) or chemical vapor deposition (CVD) and has excellent reactivity, volatility, and thermal stability; a precursor composition comprising the novel compound; and a method for manufacturing a thin film using the precursor composition.

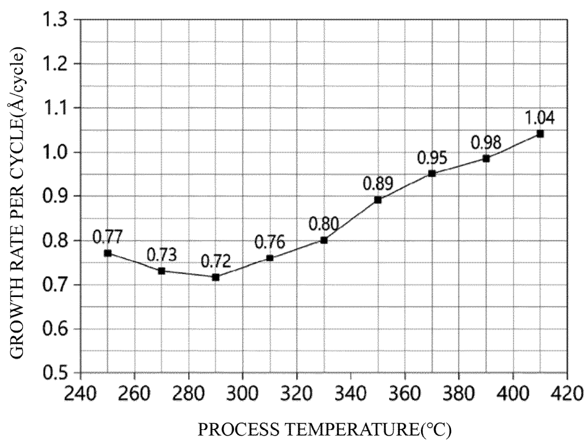


Figure 1

EP 4 737 461 A1

## Description

### Technical Field

The present disclosure relates to a novel compound capable of thin film deposition through vapor deposition, a precursor composition including the novel compound, and a method of manufacturing a thin film using the precursor composition.

### Background Art

With the increasing integration density and miniaturization of semiconductor devices, the formation of metal and metal oxide thin films having a uniform thickness has become increasingly important for applying such devices to various technologies, including microelectronics, magnetic information storage, and catalysts.

To manufacture metal and metal oxide thin films, chemical vapor deposition (CVD) or atomic layer deposition (ALD) is used. In particular, ALD, a method in which reactants are sequentially injected into and removed from a chamber, enables the formation of desired thin films, facilitates control over composition, and allows for the formation of thin films with uniform thickness. In addition, ALD exhibits excellent step coverage and, therefore, is advantageous in that a thin film can be uniformly grown on a complex and sophisticated device.

To manufacture a thin film through ALD, a precursor, which plays a key role, is required to have high volatility, high thermal stability, high reactivity in a chamber, and the like. Various ligands have been applied to date to develop precursors, and examples of representative known ligands include halogen, alkoxide, cyclopentadiene, beta-diketonate, amide, and amidinate. However, most of the known precursors are solid compounds, have low volatility or stability, or may cause problems, such as contamination by impurities generated during thin film deposition. Thus, there is a need to develop a novel precursor having excellent properties that can overcome the aforementioned disadvantages.

In particular, although silicon dioxide ($SiO_2$) has been used as the gate dielectric material of transistors to date, as the size of recent semiconductor devices has become smaller and smaller, problems such as tunneling current leakage and the resulting increase in power dissipation and heat generation have become serious. Accordingly, there is a growing demand for the development of a novel material having a high dielectric constant to replace the $SiO_2$ dielectric.

Group 4 metals, such as hafnium or zirconium, are being widely applied as high-k thin-film materials due to having relatively wide bandgap energy, high Si integration, and high compatibility. However, existing precursor materials used to prepare hafnium thin films or zirconium thin films have limitations in improving the growth rate per cycle, uniformity, flatness, purity, and the like of such thin films. Thus, there is a need for the development of improved precursors.

[Documents of related art]

[Patent Documents]

(Patent Document 1) Korean Patent Application Publication No. 2011-0065383
(Patent Document 2) Korean Patent Application Publication No. 2014-0029428

### Disclosure

### Technical Problem

The present disclosure aims to provide a novel Group 4 metal element-containing compound applicable to ALD or CVD and a precursor composition including the same.

In particular, the present disclosure aims to provide a liquid precursor composition that is purified at low temperatures, has excellent thermal stability and volatility, and is capable of thin film deposition over a wide temperature range.

Furthermore, the present disclosure aims to provide a method of manufacturing a thin film using the precursor composition.

However, the problems to be solved by the present application are not limited to the aforementioned description, and other problems not mentioned can be clearly understood by those skilled in the art from the following description.

**Technical Solution**

One aspect of the present application provides a compound represented by Formula 1 below,

[Formula 1]

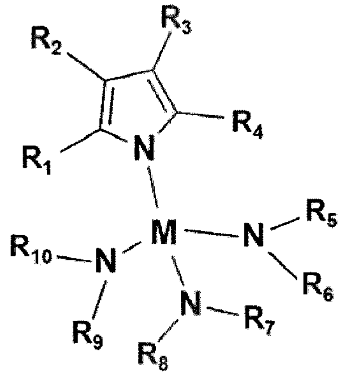

wherein in Formula 1,

M is titanium (Ti), zirconium (Zr), or hafnium (Hf),

$R_1$ to $R_4$ are each independently hydrogen, or a straight-chain or branched-chain hydrocarbon group having 1 to 6 carbon atoms, and

$R_5$ to $R_{10}$ are each independently hydrogen, or a straight-chain or branched-chain hydrocarbon group having 1 to 4 carbon atoms.

Another aspect of the present application provides a precursor composition for vapor deposition, the precursor composition including the aforementioned compound.

A further aspect of the present application provides a method of manufacturing a thin film, the method including a step of introducing the aforementioned precursor composition for vapor deposition into a chamber.

**Advantageous Effects**

A novel compound and a precursor composition including the novel compound, according to the present disclosure, have excellent reactivity, volatility, and thermal stability, are liquid, and enable deposition of a uniform thin film having excellent properties. Accordingly, the thin film can obtain excellent physical properties, thickness, and step coverage.

Such physical properties provide a precursor suitable for ALD and CVD.

**Description of Drawings**

FIG. 1 is a graph showing changes in growth rate per cycle according to changes in process temperature of a tris(dimethylamido)(2,5-di-isopropyl-1H-pyrrolyl) hafnium compound of Example 2 of the present application.

FIG. 2 is a graph showing changes in growth rate per cycle according to changes in process temperature of a tris(dimethylamido)(2,5-di-ethyl-1H-pyrrolyl) hafnium compound of Example 3 of the present application.

**Best Mode**

Hereinafter, the action and effect of the present disclosure will be described in more detail through specific embodiments of the present disclosure. However, these embodiments are provided only for illustrative purposes of the present disclosure, and the scope of the present disclosure is not limited thereby.

Prior to discussing the details, it should be noted that terms or words used herein and used in the appended claims are not construed as being limited to general and dictionary meanings but will be interpreted based on the meanings and concepts corresponding to the technical ideas of the present disclosure, following the principle that any inventor is

allowed to define the concepts of terms as appropriate to describe the disclosure thereof in the best mode.

Therefore, the embodiments described herein are configured merely as one of the most preferable examples of the present disclosure and do not exhaustively represent the technical idea of the present disclosure. Accordingly, it should be appreciated that there may be various equivalents and modifications that can replace these embodiments as of the filing date of the present application.

As used herein, the singular expressions are intended to include the plural forms unless the context clearly indicates otherwise. It will be further understood that the terms "comprise", "include", "have", and the like when used herein, are intended to specify the presence of stated features, integers, steps, constituent elements, or combinations thereof but do not preclude the possibility of the presence or addition of one or more other features, integers, steps, constituent elements, or combinations thereof.

As used herein, the expression "a to b" to represent a numerical range is defined as ≥ a and ≤ b.

A compound, according to one aspect of the present application, may be represented by Formula 1 below.

[Formula 1]

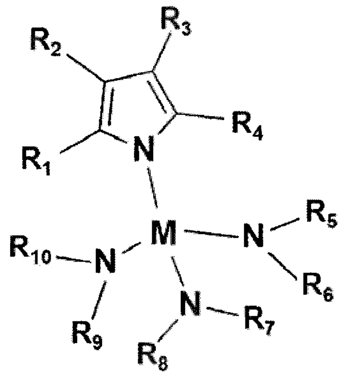

In Formula 1,

M is titanium (Ti), zirconium (Zr), or hafnium (Hf),

$R_1$ to $R_4$ are each independently hydrogen, or a straight-chain or branched-chain hydrocarbon group having 1 to 6 carbon atoms, and

$R_5$ to $R_{10}$ are each independently hydrogen, or a straight-chain or branched-chain hydrocarbon group having 1 to 4 carbon atoms.

Preferably, in one embodiment of the present application, $R_1$ to $R_4$ are each independently any one selected from the group consisting of hydrogen, a methyl group, an ethyl group, an n-propyl group, an isopropyl group, an n-butyl group, an isobutyl group, a sec-butyl group, a tert-butyl group, an n-pentyl group, an isopentyl group, a neo-pentyl group, a sec-pentyl group, a tert-pentyl group, a hexyl group, an isohexyl group, and isomers thereof.

More preferably, $R_1$ to $R_4$ are any one selected from the group consisting of hydrogen, a methyl group, an ethyl group, an n-propyl group, an isopropyl group, an n-butyl group, an isobutyl group, a sec-butyl group, and a tert-butyl group, but are not limited thereto.

Even more preferably, $R_1$ and $R_4$ are an ethyl group, an isopropyl group, or a tert-butyl group, while $R_2$ and $R_3$ are hydrogen. Compounds having hydrocarbon groups other than the aforementioned hydrocarbon groups may become solid compounds rather than being liquid. Alternatively, the thermal stability of such compounds may be poorer than that of the compound of the present application.

Preferably, in one embodiment of the present application, $R_5$ to $R_{10}$ are each independently any one selected from the group consisting of hydrogen, a methyl group, an ethyl group, an n-propyl group, an isopropyl group, an n-butyl group, an isobutyl group, a sec-butyl group, and a tert-butyl group.

More preferably, $R_5$ to $R_{10}$ are each independently any one selected from the group consisting of a methyl group, an ethyl group, an n-propyl group, and an isopropyl group, but are not limited thereto.

Even more preferably, $R_5$ to $R_{10}$ are each independently an ethyl group or a methyl group. Compounds having hydrocarbon groups other than the aforementioned hydrocarbon groups may become solid compounds rather than being liquid. Alternatively, the thermal stability of such compounds may be poorer than that of the compound of the present application.

In one embodiment of the present application, Formula 1 may be represented by Formula 1-1, 1-2, or 1-3 below.

[Formula 1-1]

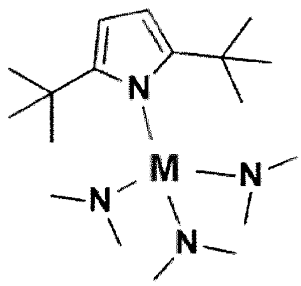

[Formula 1-2]

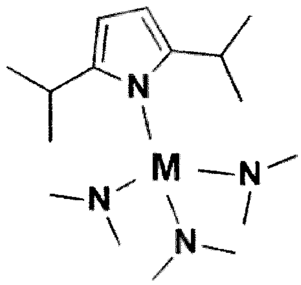

[Formula 1-3]

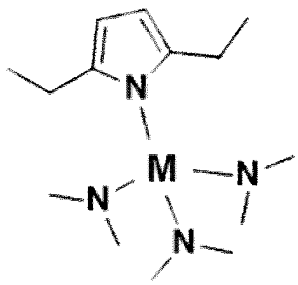

In Formulas 1-1, 1-2, and 1-3, M is titanium (Ti), zirconium (Zr), or hafnium (Hf).

In other words, examples of M(Pyrrole)(Amide) compounds represented by Formula 1 may include, but are not limited to, hafnium compounds and zirconium compounds as follows:

tris(dimethylamido)(2,5-di-tertbutyl-1H-pyrrolyl) hafnium;
tris(dimethylamido)(2,5-di-isopropyl-1H-pyrrolyl) hafnium;
tris(dimethylamido)(2,5-di-ethyl-1H-pyrrolyl) hafnium;
tris(dimethylamido)(2,5-di-tertbutyl-1H-pyrrolyl) zirconium;
tris(dimethylamido)(2,5-di-isopropyl-1H-pyrrolyl) zirconium.

In one embodiment of the present application, the compound represented by Formula 1 may be liquid at room temperature. In addition, the compound represented by Formula 1 has a low melting point and is excellent in volatility at low temperatures.

A precursor composition for vapor deposition, according to one aspect of the present application, may include any one of the compounds represented by Formula 1.

A method of manufacturing a thin film, according to one aspect of the present application, may include a step of introducing the precursor composition for vapor deposition into a chamber.

In one embodiment of the present application, the step of introducing the precursor composition for vapor deposition into the chamber may include a step of performing physical adsorption, chemical adsorption, or physical and chemical adsorption.

In one embodiment of the present application, the method of manufacturing the thin film may include both ALD

and CVD.

More specifically, the deposition method may include metal organic CVD (MOCVD), low-pressure CVD (LPCVD), pulsed CVD (P-CVD), plasma-enhanced ALD (PE-ALD), or combinations thereof.

The method of manufacturing the thin film is preferably ALD, but is not limited thereto.

In ALD, reactants are required to be highly volatile, stable, and highly reactive. ALD allows a sub-monolayer thin film to grow through a surface reaction during one cycle of deposition by supplying each reaction raw material separately. The ligand of the reaction raw material, adsorbed onto a substrate, is removed through a chemical reaction with another reaction raw material supplied later. When heating the precursor compound, serving as the reactant, for ALD, the liquid form is much more advantageous in terms of the reaction rate and process than the solid form.

In one embodiment of the present application, the method of manufacturing the thin film may further include a step of injecting at least one selected from hydrogen ($H_2$), an oxygen (O) atom-containing compound (or a mixture), a nitrogen (N) atom-containing compound (or a mixture), or a silicon (Si) atom-containing compound (or a mixture), as a reaction gas.

Specifically, at least one selected from hydrogen ($H_2$), water vapor ($H_2O$), oxygen ($O_2$), ozone ($O_3$), nitrogen ($N_2$), ammonia ($NH_3$), hydrazine ($N_2H_4$), or silane may serve as the reaction gas, but the reaction gas is not limited thereto.

More specifically, water vapor ($H_2O$), oxygen ($O_2$), and ozone ($O_3$) may serve as the reaction gas to deposit an oxide thin film, while nitrogen ($N_2$), ammonia ($NH_3$), or hydrazine ($N_2H_4$) may serve as the reaction gas to deposit a nitride thin film. In addition, hydrogen ($H_2$) or silane compounds may serve as the reaction gas to deposit a metal thin film.

Preferably, to deposit an oxide thin film, water vapor ($H_2O$), oxygen ($O_2$), ozone ($O_3$), or a combination thereof serves as the reaction gas.

In one embodiment of the present application, the method of manufacturing the thin film being ALD may include a first purge step of purging the precursor composition from the chamber before the step of injecting the reaction gas, and/or a second purge step of purging a byproduct produced by a reaction with the precursor composition and residues remaining without reacting with the precursor composition after the step of injecting the reaction gas.

The above purge steps help the precursor move on the substrate, allow the inside of the reactor to have appropriate pressure for deposition, and alternatively enable impurities and the like present inside the reactor to be released to the outside. In other words, before and after supplying the reaction gas, a purge process with an inert gas such as argon (Ar), nitrogen ($N_2$), or helium (He) may be additionally performed inside the reactor.

In one embodiment of the present application, a process temperature in the method of manufacturing the thin film may be 100°C or higher and 500°C or lower.

For example, the process temperature may be 150°C or higher and 480°C or lower, 200°C or higher and 460°C or lower, or 230°C or higher and 440°C or lower. The process temperature is preferably 250°C or higher and 410°C or lower.

In one embodiment of the present application, a canister temperature in the method of manufacturing the thin film may be -20°C or higher and 110°C or lower.

For example, the canister temperature may be 0°C or higher and 105°C or lower, 20°C or higher and 100°C or lower, 40°C or higher and 95°C or lower, 60°C or higher and 90°C or lower. 70°C or higher and 80°C or lower, -10°C, 0°C, 10°C, 20°C, 30°C, 40°C, 50°C, 60°C, 70°C, 80°C, 90°C, or 100°C. The canister temperature is preferably 80°C.

In the method of manufacturing the thin film, a canister is used to supply a source gas into the reaction chamber. Typically, a canister produces a source gas by vaporizing the precursor composition and then supplies the resulting source gas into the chamber.

When the canister temperature falls below -20°C or above 110°C, the thickness uniformity of the thin film, manufactured through the method of manufacturing the thin film, may be significantly reduced. This is because a uniform film layer is challenging to obtain due to an insufficient supply of the precursor composition into the chamber below -20°C and due to deterioration caused by thermal energy or an excessive supply of the precursor composition into the chamber above 110°C.

In one embodiment of the present application, the injection time of the precursor composition may be 1 second or more and 30 seconds or less, and the injection amount of the carrier gas for the precursor composition may be 10 sccm or more and 1000 sccm or less.

For example, the injection time of the precursor composition may be 1 second or more and 29 seconds or less, 4 seconds or more and 27 seconds or less, 7 seconds or more and 25 seconds or less, 10 seconds or more and 23 seconds or less, 13 seconds or more and 21 seconds or less, or 15 seconds or more and 20 seconds or less.

The injection amount of the purge gas in the first purge step may be 20 sccm or more and 800 sccm or less, 40 sccm or more and 700 sccm or less, 60 sccm or more and 600 sccm or less, 80 sccm or more and 500 sccm or less, 100 sccm or more and 450 sccm or less, 150 sccm or more and 400 sccm or less, or 250 sccm or more and 350 sccm or less.

When the process is performed outside the above range, it may be challenging to form an appropriate thin film.

Specifically, when the injection time of the precursor composition is less than 1 second, the reactants necessary for thin film formation may be insufficient, making it impossible to form a thin film having an appropriate thickness. On the other hand, when the injection time of the precursor composition exceeds 30 seconds, the composition ratio in the thin film

manufactured may be inconsistent due to impurities generated by the compounds remaining after the reaction.

In addition, when the injection amount of the carrier gas for the precursor composition is less than 10 sccm, the residual amount of the precursor composition serving as the reactant may increase, resulting in inappropriate reactions. Furthermore, the thin film layer may be unevenly deposited because impurities are not purged.

In one embodiment of the present application, the injection time of the reaction gas may be 1 second or more and 30 seconds or less, and the injection amount of the reaction gas may be 50 sccm or more and 3000 sccm or less.

For example, the injection time of the reaction gas may be 2 seconds or more and 25 seconds or less, 2 seconds or more and 20 seconds or less, 3 seconds or more and 15 seconds or less, or 3 seconds or more and 10 seconds or less. The injection time of the reaction gas is preferably 3 seconds or more and 7 seconds or less.

In addition, the injection amount of the reaction gas may be, for example, 100 sccm or more and 2500 sccm or less, 300 sccm or more and 2000 sccm or less, 500 sccm or more and 1500 sccm or less, 700 sccm or more and 1300 sccm or less, or 900 sccm or more and 1100 sccm or less.

In addition, when the injection amount of the reaction gas is less than 50 sccm, the residual amount of the precursor composition serving as the reactant may increase, resulting in inappropriate reactions. Furthermore, the thin film layer may be unevenly deposited due to the generation of impurities. On the other hand, when the injection amount of the reaction gas exceeds 3000 sccm, impurities may be generated by the reaction gas compound.

In one embodiment of the present application, the injection time of the purge gas in the first purge step may be 1 second or more and 1 minute or less, the injection time of the purge gas in the second purge step may be 10 seconds or more and 1 minute or less, and the injection amounts of the purge gas in the first and second purge steps may be each independently 100 sccm or more and 2000 sccm or less.

For example, the injection time of the purge gas in the first purge step may be 3 seconds or more and 55 seconds or less, 6 seconds or more and 50 seconds or less, 9 seconds or more and 45 seconds or less, 12 seconds or more and 40 seconds or less, or 15 seconds or more and 35 seconds or less, while the injection time of the purge gas in the second purge step may be 10 seconds or more and 60 seconds or less, 20 seconds or more and 55 seconds or less, or 30 seconds or more and 50 seconds or less.

Furthermore, the injection amounts of the purge gas in the first and second purge steps may be each independently 100 sccm or more and 200 sccm or less, 100 sccm or more and 300 sccm or less, 100 sccm or more and 400 sccm or less, 100 sccm or more and 500 sccm or less, 100 sccm or more and 600 sccm or less, 100 sccm or more and 700 sccm or less, 100 sccm or more and 800 sccm or less, 100 sccm or more and 900 sccm or less, 100 sccm or more and 1000 sccm or less, 100 sccm or more and 1200 sccm or less, 100 sccm or more and 1400 sccm or less, 100 sccm or more and 1600 sccm or less, 100 sccm or more and 1800 sccm or less, 200 sccm or more and 1700 sccm or less, 300 sccm or more and 1600 sccm or less, 400 sccm or more and 1600 sccm or less, 500 sccm or more and 1600 sccm or less, 600 sccm or more and 1600 sccm or less, 700 sccm or more and 1600 sccm or less, 800 sccm or more and 1600 sccm or less, or 900 sccm or more and 1600 sccm or less.

In one embodiment of the present application, the number of repetitions of the above cycle may be 10 or more.

For example, the number of repetitions of the above cycle may be 10 or more, 100 or more, 200 or more, 500 or more, 1,000 or more, 5,000 or more, 10,000 or more, 50,000 or more, or 100,000 or more and 1,000,000 or less.

When the process conditions for the reaction gas, the process temperature, the precursor composition, and the purge gas described above are not satisfied, a thin film having excellent properties is unobtainable.

## Mode for Invention

Hereinafter, the present disclosure will be described in more detail through examples. However, the following examples are intended to describe the present disclosure in more detail, and the scope of the present disclosure is not limited by the following examples.

### [Synthesis Examples]

### Synthesis Example 1: Synthesis of 2,2,7,7-tetramethyloctane-3,6-dione

Potassium hydride (in tetrahydrofuran (THF)) was added to a flask, and 3,3-dimethylbutan-2-one was slowly added thereto at 0°C and then stirred for 1 hour. Thereafter, copper(II) chloride ($CuCl_2$) (in dimethylformamide (DMF)) was slowly added at -78°C, stirred at 60°C for 3 hours, and then stirred at room temperature for 24 hours. After reducing the temperature of the flask and adding 1 M HCl to react (work up), diethyl ether, water ($H_2O$), and brine were added for compound extraction. The extracted compound was dried over $MgSO_4$ and subjected to filtration to obtain a filtrate, which was then concentrated under reduced pressure to obtain 2,2,7,7-tetramethyloctane-3,6-dione.

The structural formula and NMR measurement result of the obtained 2,2,7,7-tetramethyloctane-3,6-dione are as follows.

[Structural formula of 2,2,7,7-tetramethyloctane-3,6-dione]

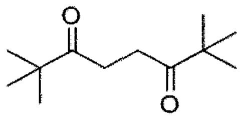

$^{1}$H-NMR (400MHz, $CDCl_3$):
δ 1.17(s, 9H), 2.76(s, 2H)

**Synthesis Example 2: Synthesis of 2,5-di-tert-butyl-1H-pyrrole ligand**

The 2,2,7,7-tetramethyloctane-3,6-dione obtained in Synthesis Example 1, acetic acid, and ammonium acetate were added to a flask and then stirred at 100°C for 4 hours. After stirring, an aqueous potassium carbonate solution was slowly added to the resulting compound, followed by compound extraction using diethyl ether, deionized water (DIW), and brine. The extracted compound was dried over $MgSO_4$ and subjected to filtration to obtain a filtrate, which was then concentrated under reduced pressure and purified. The synthesized 2,5-di-tert-butyl-1H-pyrrole, a transparent liquid compound, was obtained in 55% yield.

The structural formula and NMR measurement result of the synthesized 2,5-di-tert-butyl-1H-pyrrole are as follows.

[Structural formula of 2,5-di-tert-butyl-1H-pyrrole]

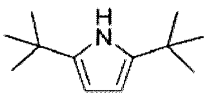

$^{1}$H-NMR (400MHz, $CDCl_3$):
δ 1.30(s, 9H), 5.8(d, 2H)

**Synthesis Example 3: Synthesis of 2,7-dimethyloctane-3,6-dione**

Potassium hydride (in THF) was added to a flask, and 3-methylbutan-2-one was slowly added thereto at 0°C and then stirred for 1 hour. Thereafter, copper(II) chloride ($CuCl_2$) (in DMF) was slowly added at -78°C and stirred at room temperature for 24 hours. After reducing the temperature of the flask and adding 1 M HCl to react (work up), diethyl ether, water ($H_2O$), and brine were added for compound extraction. The extracted compound was dried over $MgSO_4$ and subjected to filtration to obtain a filtrate, which was then concentrated under reduced pressure to obtain 2,7-dimethyloctane-3,6-dione.

The structural formula and NMR measurement result of the obtained 2,7-dimethyloctane-3,6-dione are as follows.

[Structural formula of 2,7-dimethyloctane-3,6-dione]

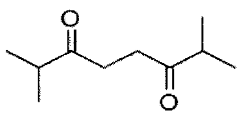

$^{1}$H-NMR (400MHz, $CDCl_3$):
δ 1.1(d, 12H), 2.6(m, 2H), 2.7(s,4H)

**Synthesis Example 4: Synthesis of 2,5-di-isopropyl-1H-pyrrole ligand**

The 2,7-dimethyloctane-3,6-dione obtained in Synthesis Example 3, acetic acid, and ammonium acetate were added to a flask and then stirred at 100°C for 4 hours. After stirring, an aqueous potassium carbonate solution was slowly added to the resulting compound, followed by compound extraction using diethyl ether, DIW, and brine. The extracted compound was dried over $MgSO_4$ and subjected to filtration to obtain a filtrate, which was then concentrated under reduced pressure and purified. The synthesized 2,5-di-isopropyl-1H-pyrrole, a transparent liquid compound, was obtained in 30% yield.

The structural formula and NMR measurement result of the synthesized 2,5-diisopropyl-1H-pyrrole are as follows.

[Structural formula of 2,5-di-isopropyl-1H-pyrrole]

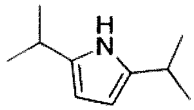

$^1$H-NMR (400MHz, $CDCl_3$):
δ 1.4(d, 12H), 2.9(m, 2H), 5.8(s, 2H)

**Synthesis Example 5: Synthesis of octane-3,6-dione**

Nitroalkane and potassium carbonate were added to a flask, dissolved in water, and then stirred at room temperature for 5 minutes. Thereafter, enone was added and stirred at room temperature for 3 hours, and 30% hydrogen peroxide was added and stirred at room temperature. After adding diethyl ether, water ($H_2O$), and brine to react (work up), the resulting product was dried over $MgSO_4$ and subjected to filtration to obtain a filtrate, which was then concentrated under reduced pressure to obtain octane-3,6-dione.

The structural formula and NMR measurement result of the obtained octane-3,6-dione are as follows.

[Structural formula of octane-3,6-dione]

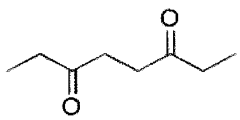

$^1$H-NMR (400MHz, $CDCl_3$):
δ 1.10(t, 6H), 2.50(q, 4H), 2.70(s, 4H)

**Synthesis Example 6: Synthesis of 2,5-di-ethyl-1H-pyrrole ligand**

The octane-3,6-dione obtained in Synthesis Example 5, acetic acid, and ammonium acetate were added to a flask and then stirred at 100°C for 4 hours. After stirring, an aqueous potassium carbonate solution was slowly added to the resulting compound, followed by compound extraction using diethyl ether, DIW, and brine. The extracted compound was dried over $MgSO_4$ and subjected to filtration to obtain a filtrate, which was then concentrated under reduced pressure and purified. The synthesized 2,5-di-ethyl-1H-pyrrole, a transparent liquid compound, was obtained in 70% yield.

The structural formula and NMR measurement result of the synthesized 2,5-diethyl-1H-pyrrole are as follows.

[Structural formula of 2,5-di-ethyl-1H-pyrrole]

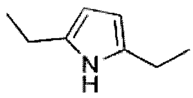

$^1$H-NMR (400MHz, $CDCl_3$):
δ 1.3(t, 6H), 2.6(q, 4H), 2.7(s, 2H)

**[Examples]**

**Example 1: Preparation of tris(dimethylamido)(2,5-di-tertbutyl-1H-pyrrolyl) hafnium**

Tetrakis(dimethylamido)hafnium (TDMAH) was added to a flask and diluted with toluene. Then, the temperature was reduced to 0°C, and 2,5-di-tert-butyl-1H-pyrrole (Synthesis Example 2) diluted in toluene was slowly added with stirring. All components were added and stirred at room temperature for 24 hours. Then, the solvent was concentrated under reduced pressure to obtain a compound, which was then purified under reduced pressure to obtain tris(dimethylamido)(2,5-di-tertbutyl-1H-pyrrolyl) hafnium. The synthesized tris(dimethylamido)(2,5-di-tertbutyl-1H-pyrrolyl) hafnium, a red liquid compound, was obtained in 40% yield.

The structural formula and NMR measurement result of the synthesized tris(dimethylamido)(2,5-di-tertbutyl-1H-pyrrolyl) hafnium are as follows.

[Structural formula of tris(dimethylamido)(2,5-di-tertbutyl-1H-pyrrolyl) hafnium]

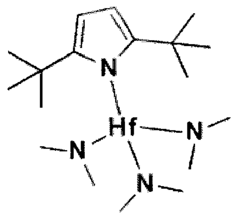

$^1$H-NMR (400MHz, $C_6D_6$):
δ 1.40(s, 18H), 2.98(s, 18H), 6.20(s,2H)

**Example 2: Preparation of tris(dimethylamido)(2,5-di-isopropyl-1H-pyrrolyl) hafnium**

TDMAH was added to a flask and diluted with toluene. Then, the temperature was reduced to 0°C, and 2,5-di-isopropyl-1H-pyrrole (Synthesis Example 4) diluted in toluene was slowly added with stirring. All components were added and stirred at room temperature for 24 hours. Then, the solvent was concentrated under reduced pressure to obtain a compound, which was then purified under reduced pressure to obtain tris(dimethylamido)(2,5-di-isopropyl-1H-pyrrolyl) hafnium. The synthesized tris(dimethylamido)(2,5-di-isopropyl-1H-pyrrolyl) hafnium, a yellow liquid compound, was obtained in 50% yield.

The structural formula and NMR measurement result of the synthesized tris(dimethylamido)(2,5-di-isopropyl-1H-pyrrolyl) hafnium are as follows.

[Structural formula of tris(dimethylamido)(2,5-di-isopropyl-1H-pyrrolyl) hafnium]

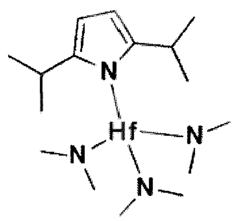

$^1$H-NMR (400MHz, $C_6D_6$):
δ 1.35(d, 12H), 2.98(s, 18H), 3.09(m, 2H), 6.18(s,2H)

**Example 3: Preparation of tris(dimethylamido)(2,5-di-ethyl-1H-pyrrolyl) hafnium**

TDMAH was added to a flask and diluted with toluene. Then, the temperature was reduced to 0°C, and 2,5-di-ethyl-1H-pyrrole (Synthesis Example 6) diluted in toluene was slowly added with stirring. All components were added and stirred at room temperature for 24 hours. Then, the solvent was concentrated under reduced pressure to obtain a compound, which was then purified under reduced pressure to obtain tris(dimethylamido)(2,5-di-ethyl-1H-pyrrolyl) hafnium. The synthesized tris(dimethylamido)(2,5-di-ethyl-1H-pyrrolyl) hafnium, a yellow liquid compound, was obtained in 50% yield.

The structural formula and NMR measurement result of the synthesized tris(dimethylamido)(2,5-di-ethyl-1H-pyrrolyl) hafnium are as follows.

[Structural formula of tris(dimethylamido)(2,5-di-ethyl-1H-pyrrolyl) hafnium]

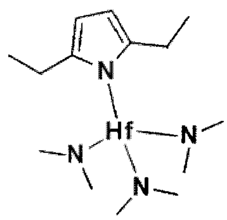

$^1$H-NMR (400MHz, $C_6D_6$):
δ 1.3(t, 6H), 2.7(q, 4H), 2.9(s, 18H), 6.1(s, 2H)

**Example 4: Preparation of tris(dimethylamido)(2,5-di-tertbutyl-1H-pyrrolyl) zirconium**

Tetrakis(dimethylamido)zirconium (TDMAZ) was added to a flask and diluted with toluene. Then, the temperature was reduced to 0°C, and 2,5-di-tert-butyl-1H-pyrrole (Synthesis Example 2) diluted in toluene was slowly added with stirring. All components were added and stirred at room temperature for 24 hours. Then, the solvent was concentrated under reduced pressure to obtain a compound, which was then purified under reduced pressure to obtain tris(dimethylamido)(2,5-di-tertbutyl-1H-pyrrolyl) zirconium. The synthesized tris(dimethylamido)(2,5-di-tertbutyl-1H-pyrrolyl) zirconium, a red liquid compound, was obtained in 38% yield.

The structural formula and NMR measurement result of the synthesized tris(dimethylamido)(2,5-di-tertbutyl-1H-pyrrolyl) zirconium are as follows.

[Structural formula of tris(dimethylamido)(2,5-di-tertbutyl-1H-pyrrolyl) zirconium]

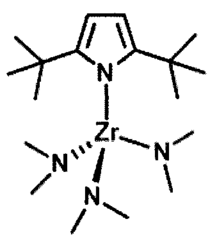

$^1$H-NMR (400MHz, $C_6D_6$):
δ 1.40(s, 18H), 2.96(s, 18H), 6.19(s,2H)

**Example 5: Preparation of tris(dimethylamido)(2,5-di-isopropyl-1H-pyrrolyl) zirconium**

TDMAZ was added to a flask and diluted with toluene. Then, the temperature was reduced to 0°C, and 2,5-di-isopropyl-1H-pyrrole (Synthesis Example 4) diluted in toluene was slowly added with stirring. All components were added and stirred at room temperature for 24 hours. Then, the solvent was concentrated under reduced pressure to obtain a compound, which was then purified under reduced pressure to obtain tris(dimethylamido)(2,5-di-isopropyl-1H-pyrrolyl) zirconium. The synthesized tris(dimethylamido)(2,5-di-isopropyl-1H-pyrrolyl) zirconium, a yellow liquid compound, was obtained in 51% yield.

The structural formula and NMR measurement result of the synthesized tris(dimethylamido)(2,5-di-isopropyl-1H-pyrrolyl) zirconium are as follows.

[Structural formula of tris(dimethylamido)(2,5-di-isopropyl-1H-pyrrolyl) zirconium]

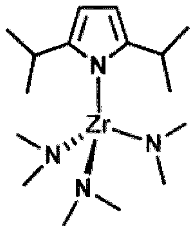

$^1$H-NMR (400MHz, $C_6D_6$):
δ 1.34(d, 12H), 2.97(s, 18H), 3.05(m, 2H), 6.16(s,2H)

**[Preparation Examples]**

**Preparation Example 1: Hafnium thin film manufacture 1 using ALD**

A hafnium thin film was manufactured through ALD using the hafnium compound (tris(dimethylamido)(2,5-di-isopropyl-1H-pyrrolyl) hafnium) synthesized in Example 2 as a precursor.

A substrate used in this experiment was a p-type Si wafer with a resistivity of 0.02 Ω·cm. Before deposition, the p-type Si wafer was sonicated in acetone, ethanol, and DIW for 10 minutes each, followed by cleaning. The native oxide thin film on the Si wafer was immersed in a 10% HF solution ($HF:H_2O$ = 1:9) for 10 seconds and then removed. The HF-cleaned Si wafer was immediately transferred to an ALD chamber.

Water vapor ($H_2O$) served as a reaction gas and was injected at a flow rate of 1,000 sccm by controlling the on/off of the pneumatic valve. Argon (Ar), an inert gas, was used to purge the precursor compound and the reaction gas, and the flow rate thereof was set to 1,500 sccm.

(Precursor injection for 20 seconds) - (purge gas injection for 35 seconds) - (reaction gas injection for 5 seconds) - (purge gas injection for 50 seconds) were performed sequentially, which was defined as one cycle.

A canister temperature was maintained at 80°C, a process temperature was set to be in the range of 250°C to 410°C, and the number of cycles was set to 100 to deposit a hafnium oxide film.

**Preparation Example 2: Hafnium thin film manufacture 2 using ALD**

A hafnium oxide film was manufactured through ALD using the hafnium compound (tris(dimethylamido)(2,5-di-ethyl-1H-pyrrolyl) hafnium) synthesized in Example 3 as a precursor.

The hafnium thin film was deposited under the same conditions as in Preparation Example 1, except that the injection time of the precursor was 15 seconds, the injection time of the purge gas in the first purge step was 15 seconds, and the injection time of the purge gas in the second purge step was 30 seconds.

Table 1 below shows the process conditions for manufacturing the thin films in Preparation Examples 1 and 2.

[Table 1]

| | Canister temperature (°C) | Process temperature (°C) | Precursor injection time (s) | First purge time (s) | Reaction gas injection time (s) | Second purge time (s) | ALD cycle (number) |
|---|---|---|---|---|---|---|---|
| Preparation Example 1 | 80 | 250 to 410 | 20 | 35 | 5 | *50* | 100 |

(continued)

| | Canister temperature (°C) | Process temperature (°C) | Precursor injection time (s) | First purge time (s) | Reaction gas injection time (s) | Second purge time (s) | ALD cycle (number) |
|---|---|---|---|---|---|---|---|
| Preparation Example 2 | 80 | 250 to 410 | 15 | 15 | 5 | 30 | 100 |

**Preparation Example 3: Zirconium thin film manufacture using ALD**

A zirconium oxide film was manufactured through ALD in the same manner as in Preparation Examples 1 and 2 (using water vapor ($H_2O$) as a reaction gas), except that some process conditions were appropriately adjusted using the zirconium compound (tris(dimethylamido)(2,5-di-tertbutyl-1H-pyrrolyl) zirconium) synthesized in Example 4 as a precursor.

In addition, a zirconium oxide film was manufactured through ALD in the same manner as in Preparation Examples 1 and 2 (using water vapor ($H_2O$) as a reaction gas) by appropriately adjusting some process conditions, except that some process conditions were appropriately adjusted using the zirconium compound (tris(dimethylamido)(2,5-diisopropyl-1H-pyrrolyl) zirconium) synthesized in Example 5 as a precursor.

The growth rates per cycle of the thin films manufactured according to Preparation Examples 1 and 2 were analyzed.

**Evaluation Example 1: Measurement of growth rate per cycle**

Under the process conditions described in Table 1, thin films were manufactured according to the above preparation examples by varying process temperatures within the range of 250°C to 410°C, and the growth rates per cycle (GPC) of the thin films were measured. The GPC for Preparation Example 1 is shown in FIG. 1, and the GPC for Preparation Example 2 is shown in FIG. 2.

The GPC was calculated by Equation 1 below.

[Equation 1]

$$\text{GPC (Å/cycle)} = \text{deposition thickness/number of ALD cycles}$$

The deposition thickness for Equation 1 was measured using an ellipsometer and confirmed using a field emission scanning electron microscope (FE-SEM).

As shown in FIGS. 1 and 2, a region where the GPC remains constant regardless of the process temperature (ALD window) is observed in the temperature range of 270°C to 330°C for Preparation Example 1 using the compound of Example 2, and in the temperature range of 250°C to 330°C for Preparation Example 2 using the compound of Example 3. In this respect, it was confirmed that deposition was possible by ALD when using the precursor compounds for vapor deposition, including the novel compounds of Examples 2 and 3, respectively, and Hf metal thin films could be manufactured.

It was confirmed that the GPC was 0.65 or more and 1.10 or less when using the compound of Example 2, while the GPC was 0.60 or more and 1.00 or less when using the compound of Example 3.

In addition, as shown in FIGS. 1 and 2, a region where the process temperature and GPC increase proportionally is observed in the temperature range of 330°C to 410°C, confirming that such patterns are similar to those observed when deposited by CVD. Therefore, it was confirmed that the precursor composition of the present application could also be used in CVD.

Even when deposited using the precursor composition for vapor deposition, including the novel compound of Example 1, a hafnium (Hf) metal thin film was confirmed to be deposited as in Preparation Examples 1 and 2.

In addition, even when deposited using the precursor composition for vapor deposition, including the novel compound of Example 4, and the precursor composition for vapor deposition, including the novel compound of Example 5, zirconium metal thin films were confirmed to be formed.

From the thin film manufacture, it was seen that deposition by ALD using the novel compound of the present application as a precursor composition for deposition enabled the formation of a thin film having excellent properties, and that deposition by CVD was also possible using the novel compound of the present application as a precursor composition for deposition.

The scope of the present disclosure is defined by the appended claims rather than the detailed description presented above. All changes or modifications derived from the meaning and scope of the claims and the concept of equivalents should be construed to fall within the scope of the present disclosure.

## Industrial Applicability

A novel compound and a precursor composition including the novel compound, according to the present disclosure, have excellent reactivity, volatility, and thermal stability, are liquid, and enable deposition of a uniform thin film having excellent properties. Accordingly, the thin film can obtain excellent physical properties, thickness, and step coverage.

Such physical properties provide a precursor suitable for ALD and CVD.

## Claims

1. A compound represented by Formula 1 below

[Formula 1]

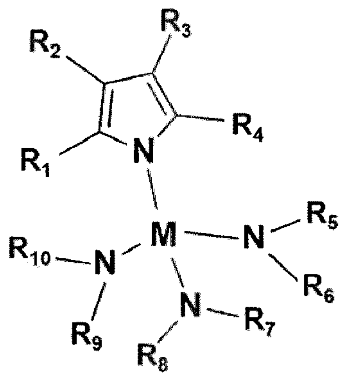

wherein in Formula 1,

M is titanium (Ti), zirconium (Zr), or hafnium (Hf),
$R_1$ to $R_4$ are each independently hydrogen, or a straight-chain or branched-chain hydrocarbon group having 1 to 6 carbon atoms, and
$R_5$ to $R_{10}$ are each independently hydrogen, or a straight-chain or branched-chain hydrocarbon group having 1 to 4 carbon atoms.

2. The compound of claim 1, wherein $R_1$ to $R_4$ are each independently any one selected from the group consisting of hydrogen, a methyl group, an ethyl group, an n-propyl group, an isopropyl group, an n-butyl group, an isobutyl group, a sec-butyl group, and a tert-butyl group.

3. The compound of claim 1, wherein $R_5$ to $R_{10}$ are each independently any one selected from the group consisting of a methyl group, an ethyl group, an n-propyl group, and an isopropyl group.

4. The compound of claim 1, wherein the compound is represented by Formula 1-1, 1-2, or 1-3 below,

[Formula 1-1]

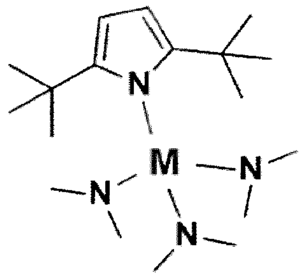

[Formula 1-2]

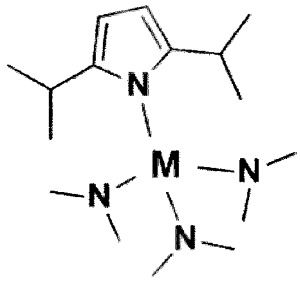

[Formula 1-3]

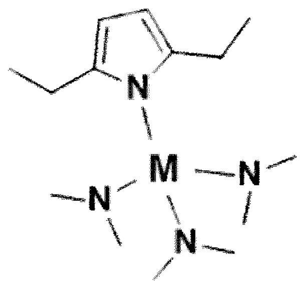

wherein in Formulas 1-1, 1-2, and 1-3,
M is titanium (Ti), zirconium (Zr), or hafnium (Hf).

5. A precursor composition for vapor deposition, the precursor composition comprising the compound of any one of claims 1 to 4.

6. A method of manufacturing a thin film, the method comprising:
introducing the precursor composition of claim 5 into a chamber.

7. The method of claim 6, wherein the method comprises atomic layer deposition (ALD) or chemical vapor deposition (CVD).

8. The method of claim 6, further comprising:
injecting at least one selected from hydrogen ($H_2$), an oxygen (O) atom-containing compound, a nitrogen (N) atom-containing compound, or a silicon (Si) atom-containing compound, as a reaction gas.

9. The method of claim 8, wherein the reaction gas is at least one selected from hydrogen ($H_2$), water vapor ($H_2O$), oxygen ($O_2$), ozone ($O_3$), nitrogen ($N_2$), ammonia ($NH_3$), hydrazine ($N_2H_4$), or silane.

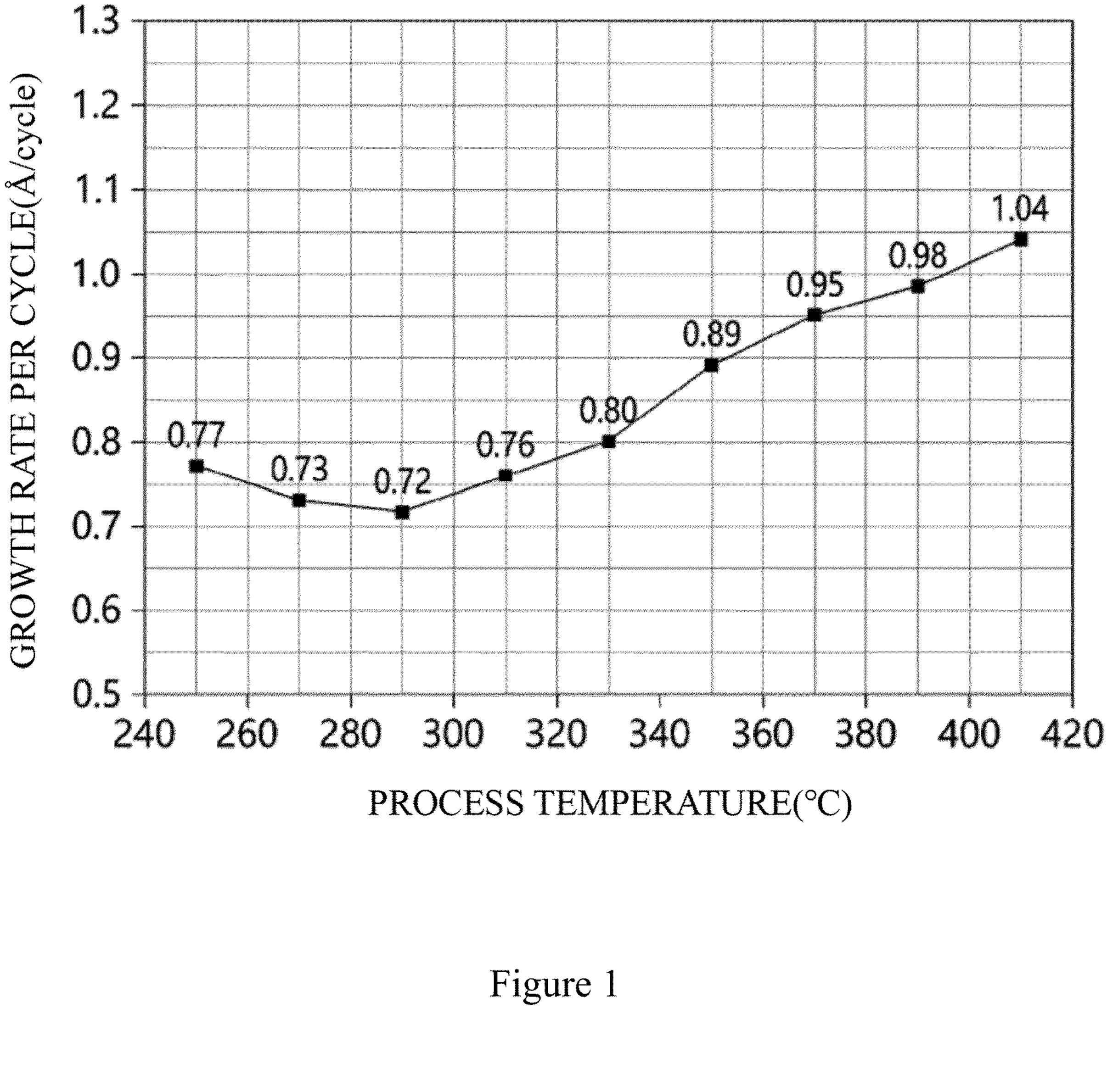
1.3
1.2
1.1
1.0
0.9
0.8
0.7
0.6
0.5
GROWTH RATE PER CYCLE(Å/cycle)
0.77
0.73
0.72
0.76
0.80
0.89
0.95
0.98
1.04
240
260
280
300
320
340
360
380
400
420
PROCESS TEMPERATURE(°C)

Figure 1

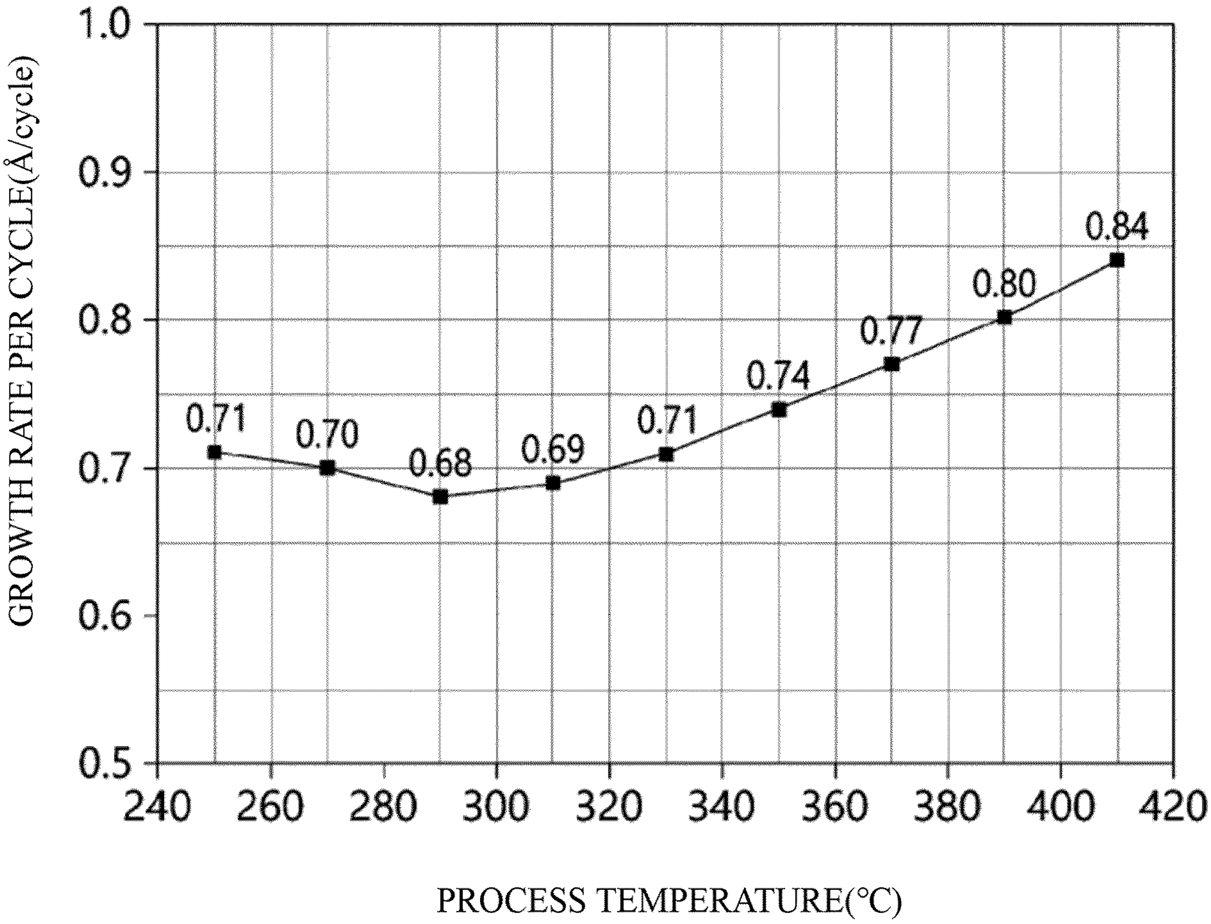
1.0
0.9
0.8
0.7
0.6
0.5
GROWTH RATE PER CYCLE(Å/cycle)
0.71
0.70
0.68
0.69
0.71
0.74
0.77
0.80
0.84
240
260
280
300
320
340
360
380
400
420
PROCESS TEMPERATURE(℃)

Figure 2

## INTERNATIONAL SEARCH REPORT

International application No.
**PCT/KR2024/008949**

**A. CLASSIFICATION OF SUBJECT MATTER**

**C07F 7/00**(2006.01)i; **C07F 7/28**(2006.01)i; **C23C 16/18**(2006.01)i; **C23C 16/455**(2006.01)i

According to International Patent Classification (IPC) or to both national classification and IPC

**B. FIELDS SEARCHED**

Minimum documentation searched (classification system followed by classification symbols)

C07F 7/00(2006.01); C07D 207/06(2006.01); C07F 7/28(2006.01); C23C 16/00(2006.01); C23C 16/06(2006.01); C23C 16/18(2006.01); C23C 16/448(2006.01); C23C 16/455(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal), STN (Registry, Caplus), Google & keywords: 박막(thin film), 전구체(precursor), 피롤(pyrrole), 기상 증착(vapor deposition), 티타늄(titanium), 지르코늄(zirconium), 하프늄(hafnium)

**C. DOCUMENTS CONSIDERED TO BE RELEVANT**

| Category* | Citation of document, with indication, where appropriate, of the relevant passages | Relevant to claim No. |
|---|---|---|
| X | WO 2009-155507 A1 (SIGMA-ALDRICH CO.) 23 December 2009 (2009-12-23)<br>See claims 1, 5, 6, 8 and 15; and figure 1. | 1-9 |
| X | DE 4120344 A1 (KALI CHEMIE AG) 02 January 1992 (1992-01-02)<br>See claims 1-4, 7, 9 and 13; and column 2, lines 60-66; column 9, example 2 and column 10, example 3. | 1-9 |
| X | WO 2013-177292 A1 (L`AIR LIQUIDE, SOCIETE ANONYME POUR L`ETUDE ET L'EXPLOITATION DES PROCEDES GEORGES CLAUDE et al.) 28 November 2013 (2013-11-28)<br>See page 5, lines 32-33; page 6, lines 25-30; page 11, lines 31-32 and page 25, example 1. | 1-9 |
| X | WO 2013-177284 A1 (L`AIR LIQUIDE, SOCIETE ANONYME POUR L`ETUDE ET L'EXPLOITATION DES PROCEDES GEORGES CLAUDE et al.) 28 November 2013 (2013-11-28)<br>See claims 1, 22, 27, 28, 31 and 32. | 1-9 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **30 September 2024** | **30 September 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.
**PCT/KR2024/008949**

**C. DOCUMENTS CONSIDERED TO BE RELEVANT**

| Category* | Citation of document, with indication, where appropriate, of the relevant passages | Relevant to claim No. |
|---|---|---|
| X | WO 2013-177269 A2 (L`AIR LIQUIDE, SOCIETE ANONYME POUR L`ETUDE ET L'EXPLOITATION DES PROCEDES GEORGES CLAUDE et al.) 28 November 2013 (2013-11-28)<br>See claims 1, 3, 21, 26 and 27; and page 25, example 1 and page 41, line 5. | 1-9 |

Form PCT/ISA/210 (second sheet) (July 2022)

**INTERNATIONAL SEARCH REPORT**
**Information on patent family members**

International application No.
**PCT/KR2024/008949**

| Patent document cited in search report | Publication date (day/month/year) | Patent family member(s) | Publication date (day/month/year) |
|---|---|---|---|
| WO 2009-155507 A1 | 23 December 2009 | TW 201014924 A | 16 April 2010 |
| | | TW 201014925 A | 16 April 2010 |
| | | WO 2009-155520 A1 | 23 December 2009 |
| DE 4120344 A1 | 02 January 1992 | None | |
| WO 2013-177292 A1 | 28 November 2013 | TW 201408679 A | 01 March 2014 |
| WO 2013-177284 A1 | 28 November 2013 | TW 201402586 A | 16 January 2014 |
| WO 2013-177269 A2 | 28 November 2013 | TW 201410688 A | 16 March 2014 |
| | | WO 2013-177269 A3 | 27 February 2014 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 20110065383
- KR 20140029428